(19) Europäisches Patentamt
European Patent Office
Office européen des brevets

(11) **EP 3 746 395 B1**

(12) **FASCICULE DE BREVET EUROPEEN**

(45) Date de publication et mention de la délivrance du brevet:
**10.11.2021  Bulletin 2021/45**

(21) Numéro de dépôt: **19701536.5**

(22) Date de dépôt: **30.01.2019**

(51) Int Cl.:
*B82Y 30/00* [(2011.01)]     *C23C 14/22* [(2006.01)]
*C23C 14/04* [(2006.01)]     *C23C 14/14* [(2006.01)]
*H01J 37/317* [(2006.01)]     *H01J 37/301* [(2006.01)]
*H01J 37/34* [(2006.01)]     *H01J 49/04* [(2006.01)]

(86) Numéro de dépôt international:
**PCT/EP2019/052272**

(87) Numéro de publication internationale:
**WO 2019/149763 (08.08.2019 Gazette 2019/32)**

(54) **DISPOSITIF DE DÉPÔT DE PARTICULES DE TAILLE NANOMÉTRIQUE SUR UN SUBSTRAT**

VORRICHTUNG ZUR ABSCHEIDUNG VON IM NANOMETERBEREICH TEILCHEN AUF EINEM SUBSTRAT

DEVICE FOR DEPOSITING NANOMETER-SIZED PARTICLES ONTO A SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **30.01.2018  FR 1850744**

(43) Date de publication de la demande:
**09.12.2020  Bulletin 2020/50**

(73) Titulaire: **Commissariat à l'Energie Atomique et aux Energies Alternatives
75015 Paris (FR)**

(72) Inventeurs:
• **SUBLEMONTIER, Olivier
91191 GIF Cedex (FR)**
• **ROUSSEAU, Youri
78600 MAISONS LAFFITTE (FR)**
• **PETIT, Christian
25800 VALDAHON (FR)**
• **MULLER, Christophe
25800 VALDAHON (FR)**
• **BILLARD, Alain
25400 EXINCOURT (FR)**
• **BRIOIS, Pascal
25200 BETHONCOURT (FR)**
• **PERRY, Frédéric
25460 ETUPES (FR)**
• **GASTON, Jean-Paul
91810 VERT LE GRAND (FR)**

(74) Mandataire: **Gevers & Orès
Immeuble le Palatin 2
3 Cours du Triangle
CS 80165
92939 Paris La Défense Cedex (FR)**

(56) Documents cités:
EP-A1- 2 553 135     EP-A1- 2 695 967
WO-A1-2006/037153     GB-A- 2 530 562

Description

L'invention se rapporte au domaine de la synthèse des matériaux composites nanostructurés.

Ces matériaux sont formés par des nanoparticules enrobées ou non dans une matrice d'un matériau différent.

Par nanoparticules, on entend des particules, généralement solides, dont la taille est comprise entre 1 nm (nanomètre) et quelques centaines de nanomètres.

Les matériaux composites nanostructurés présentent des propriétés singulièrement différentes de celles du même matériau à l'état massif, en particulier en fonction de la taille des nanoparticules enrobées dans la matrice.

Il existe différentes techniques pour former de tels matériaux sur une surface cible, ci-après le substrat, telles que décrites dans les documents de l'art antérieur GB 2530562 A et EP 2553135 B1.

L'une d'entre elles consiste à coupler deux systèmes distincts, l'un pour déposer les nanoparticules sur un substrat, l'autre pour déposer la matrice sur ledit substrat, matrice dans laquelle les nanoparticules sont destinées à être enrobées, le cas échéant.

Il est connu dans le document de l'art antérieur EP 2695967 A1 un dispositif comprenant une chambre de dépôt et un système pour générer un jet de nanoparticules dans un gaz porteur. La chambre de dépôt comporte un système de dépôt, qui peut être formé par une ou plusieurs cathodes de pulvérisation magnétron, d'une matrice sur un substrat. Le système pour générer un jet de nanoparticules comprend une chambre d'expansion munie d'un orifice de sortie des nanoparticules vers la chambre de synthèse. Dans ce dispositif, la distance entre l'orifice de sortie de la chambre d'expansion et le substrat est réglable.

Ce dispositif présente l'avantage de produire des revêtements homogènes et de permettre la synthèse d'un matériau composite nanostructuré avec un choix potentiellement illimité dans les natures chimiques respectives du cœur des nanoparticules et de la matrice qui les enrobe. Par « revêtement homogène » on entend un revêtement dont l'épaisseur d'une part, et la concentration locale en nanoparticules dans les trois dimensions d'autre part sont sensiblement constantes.

Toutefois, un inconvénient du dispositif évoqué est qu'il permet une homogénéité sur des surfaces d'étendue limitée, typiquement de l'ordre de la dizaine de centimètres carrés.

Les applications industrielles exigent de pouvoir produire des substrats dont le revêtement est homogène sur des surfaces plus grandes, et par exemple d'au moins la centaine de centimètres carrés.

Partant du dispositif de l'art antérieur évoqué, une possibilité consiste à éloigner le substrat du système pour générer un jet de nanoparticules de sorte à permettre le revêtement d'une surface plus importante en exploitant la divergence du jet de nanoparticules, Cependant, la pression de travail dans la chambre d'expansion est de l'ordre de $5.10^{-3}$ mbar pour faire fonctionner la pulvérisation magnétron dans des conditions standards. Dans ce cas, l'allongement de la distance entre la source du jet de nanoparticules et le substrat devient trop importante pour garantir l'intégrité du jet. Une autre possibilité consiste à utiliser un système pour générer des jets de nanoparticules, plus volumineux. Mais une homothétie de rapport $\alpha$ du substrat requiert également des moyens de pompage multipliés par a. Un tel système de pompage induit des coûts supplémentaires incompatibles avec des applications industrielles. Une autre raison réside dans les propriétés intrinsèques du gaz porteur et notamment sa viscosité dynamique, ce qui implique que ses propriétés d'écoulement ne sont pas transposables par une simple homothétie. De ce fait, les trajectoires des nanoparticules sont difficiles à prédire et l'homogénéité des dépôts n'est alors pas garantie.

L'invention vise à remédier à l'un au moins des inconvénients précités.

En particulier, un objectif est de permettre le revêtement homogène de substrats sur des surfaces plus grandes que dans l'état de l'art, et par exemple au moins égale à 100 cm$^2$.

A cet effet, l'invention propose un dispositif de dépôt de particules de taille nanométrique sur un substrat dans lequel le dispositif comprend :

- des moyens dits de production chacun apte à produire, à partir d'une extrémité des moyens de production, un jet de particules de taille nanométrique, chacun desdits moyens de production étant configuré pour présenter un axe longitudinal orienté dans une première direction X définissant un axe de propagation du jet, et configuré de sorte que le jet est divergent à partir d'un point P de divergence avec un demi-angle de divergence $\alpha$ par rapport à son axe de propagation, les moyens de production étant agencés de sorte que les différents axes longitudinaux sont parallèles entre eux et sous la forme d'au moins une première colonne et une deuxième colonne décalées l'une par rapport à l'autre selon une deuxième direction Y orthogonale à la première direction X où la première colonne 9 et la deuxième colonne comportent chacune au moins un moyen de production, ledit au moins un moyen de production de la première colonne étant par ailleurs décalé par rapport audit au moins un moyen de production de la deuxième colonne selon une troisième direction Z à la fois orthogonale à la première direction X et à la deuxième direction Y,
- une chambre d'expansion dans laquelle logent au moins chaque extrémité des moyens de production ;
- une chambre de dépôt comportant :

  • ledit substrat
  • un moyen de préhension du substrat, apte à déplacer ledit substrat dans la deuxième direction

Y

- une pluralité de masques comportant chacun une ouverture, chaque masque étant situé, selon la première direction X définissant la direction de propagation du jet, entre un moyen de production et le substrat si bien que lesdits masques se présentent également sous la forme d'au moins une première colonne et une deuxième colonne décalées l'une par rapport à l'autre selon la deuxième direction Y où la première colonne et la deuxième colonne comportent chacune au moins un masque, ledit au moins un masque de la première colonne étant par ailleurs décalé par rapport audit au moins un masque de la deuxième colonne selon la troisième direction Z, et si bien que, toujours selon la première direction X définissant la propagation du jet, les masques sont séparés par une première distance $d_1$ du point P de divergence du jet et par une deuxième distance $d_2$ du substrat et chaque ouverture étant munie d'un centre par lequel passe l'axe longitudinal du moyen de production associé, les centres de deux ouvertures les plus proches et appartenant à des colonnes différentes étant séparées d'une distance a selon la troisième direction Z et d'une distance b selon la deuxième direction Y,

    chaque ouverture d'un masque étant inscriptible dans un cercle de diamètre $2d_1 sin\alpha$,
    l'ouverture dudit au moins un masque de la première colonne définissant :

- une première portion, centrale, dont la largeur $L_1$, définie selon la deuxième direction Y, est constante, et dont la hauteur $H_1$, définie selon la troisième direction Z, est également constante,
- une deuxième portion 21, dont la largeur $L_3$, définie selon la deuxième direction Y, est variable selon la troisième direction Z,

l'ouverture dudit au moins un masque de la deuxième colonne définissant :

- une troisième portion, centrale, dont la largeur $L_2$, définie selon la deuxième direction Y, est constante et égale à la largeur $L_1$, et dont la hauteur $H_3$, définie selon la troisième direction Z, est également constante, et
- une quatrième portion 22, dont la largeur $L_4$, définie selon la deuxième direction Y, est variable selon la troisième direction Z,

lesdites deuxième portion et quatrième portion étant d'une part situées entre lesdites première portion et troisième portion et présentant d'autre part une hauteur maximale $H_2$, définie selon la troisième direction Z, iden-tique,
la somme $S = L_3 + L_4$ des largeurs variables selon la troisième direction de la deuxième portion et de la quatrième portion desdits masques, lorsque ces derniers sont mis en vis-à-vis selon la troisième direction Z, étant constante et égale à $L_1$, les relations suivantes étant en outre respectées :

$$a = \frac{1}{f}\left(\frac{H_1}{2} + H_2 + \frac{H_3}{2}\right) \quad et \quad b \geq \frac{1}{f}\frac{L_1}{2}$$

où :

$$f = \frac{d_1}{d_1 + d_2}$$

Un tel dispositif permet avantageusement d'obtenir un revêtement homogène de substrats sur de grandes surfaces. En particulier ce dispositif permet ainsi de produire des revêtements homogènes de l'ordre de la centaine de centimètres carrés levant le verrou technique qui jusqu'alors empêchait les industries d'utiliser ce type de revêtement.

Diverses caractéristique supplémentaires peuvent être prévues seules ou en combinaison :

- l'ouverture dudit au moins un masque de la première colonne et l'ouverture dudit au moins un masque de la deuxième colonne ont des formes différentes.

- l'ouverture dudit au moins un masque de la première colonne et l'ouverture dudit au moins un masque de la deuxième colonne ont des formes identiques.

- l'ouverture dudit au moins un masque de la première colonne et l'ouverture dudit au moins un masque de la deuxième colonne présentent une forme hexagonale.

- le masque comprend une bande qui s'étend selon la troisième direction Z et séparant chaque ouverture en deux.

- il est prévu au moins un système de dépôt d'une matrice sur le substrat.

- il est prévu une pluralité de systèmes de dépôt d'une matrice sur la substrat, lesdits systèmes de dépôt étant agencés de manière symétrique par rapport à la première direction X.

- la position du ou de chaque système de dépôt de la matrice sur le substrat est réglable, par exemple pour faire varier la distance entre ledit système et le substrat et/ou l'angle de dépôt de la matrice par rapport au substrat.

L'invention propose également un ensemble comportant un dispositif selon l'invention et un système d'acheminement de particules destiné à alimenter les moyens de production dudit dispositif, le système comprenant des moyens aptes à générer un aérosol, un orifice critique, un séparateur de flux, une bride de distribution aux moyens de production et un volume tampon situé entre l'orifice critique et le séparateur de flux, système dans lequel, l'orifice critique est placé avant le séparateur de flux.

Cet ensemble pourra comprendre l'une au moins des caractéristiques additionnelles suivantes, prises seules ou en combinaison :

- le volume du ou des canalisations entre l'orifice critique et le séparateur de flux est inférieure ou égale à 10 cm³.

- des canalisations entre le séparateur de flux et la bride de distribution sont droites ou faiblement courbées.

D'autres particularités et avantages de l'invention apparaîtront encore dans la description ci-après en relation avec les dessins annexés, donnés à titre d'exemples non limitatifs dans lesquels :

- la figure 1 est une représentation schématique de dessus du dispositif selon l'invention ;
- la figure 2 est une représentation schématique de côté du dispositif représenté sur la figure 1 ;
- la figure 3a est une vue de face de plusieurs masques utilisés dans le dispositif des figures 1 et 2 et disposés selon l'invention ;
- la figure 3b est une vue de face d'un dépôt obtenu sur un substrat avec les masques disposés selon la figure 3a ;
- la figure 4a est une vue de face de plusieurs masques selon une variante de réalisation de l'invention ;
- la figure 4b est une vue de face d'un dépôt obtenu sur un substrat avec des masques disposés selon la figure 4a ;
- la figure 5 est une vue de face d'un dépôt sur le substrat à partir du masque de la figure 4a ;
- la figure 6a est une vue de face de plusieurs masques selon une variante de réalisation de l'invention ;
- la figure 6b est une vue de face d'un dépôt obtenu sur un substrat avec des masques disposés selon la figure 6a ;
- la figure 7 est un représentation schématique d'un système d'acheminement des particules selon l'invention.

Dans la suite de la description, on adoptera par convention le repère orthogonal direct défini comme suit :

- un axe X définissant une première direction, qui correspond à la direction de propagation des jets 3 de particules,
- un axe Y orthogonal à l'axe X et définissant une deuxième direction ainsi qu'un plan XY,
- un axe Z à la fois orthogonal à l'axe Y et à l'axe X et définissant une troisième direction ainsi que des plans ZY et ZX.

Dans les modes de réalisation représentés sur les figures annexées, l'axe Z est confondu avec un axe vertical en référence à la gravité terrestre. Toutefois, selon l'orientation du dispositif 1, l'axe Z peut être distinct de cet axe vertical.

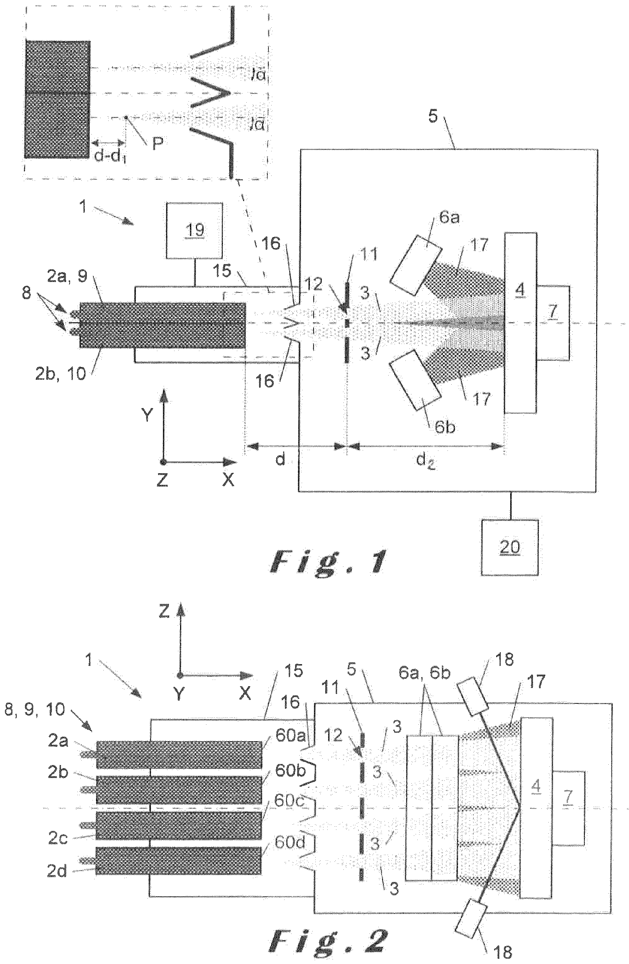

Sur les figures 1 et 2, est représenté un dispositif 1 de dépôt de particules de taille nanométrique sur un substrat 4.

Le dispositif 1 comprend une pluralité de moyens 2a, 2b, 2c, 2d aptes à produire chacun un jet 3 de particules de taille nanométrique. Dans ce qui suit, ces moyens 2a, 2b, 2c, 2d sont dénommés moyens 2a, 2b, 2c, 2d de production. Plus précisément, chacun de ces moyens de production produit un jet 3 de particules dans un gaz porteur. Chaque moyen de production est ainsi apte à produire un jet 3 selon la première direction (X) en direction d'un substrat 4, cette première direction se confondant avec un axe longitudinal de chaque moyen de production 2a, 2b, 2c, 2d. Cette première direction X définit un axe de propagation du jet 3 de particules. Par ailleurs, chacun de ces moyens de production est configuré de sorte que le jet 3 de particules de taille nanométrique ainsi produit est divergent à partir d'un point P de divergence avec un demi-angle de divergence α par rapport à l'axe de propagation du jet 3.

Ces moyens de production sont associés à une chambre d'expansion 15, destinée à être mise sous un vide poussé.

La chambre 15 d'expansion comprend ainsi au moins une extrémité 60a, 60b, 60c, 60d des moyens 2a, 2b, 2c, 2d de production. Les moyens 2a, 2b, 2c, 2d de production sont par exemple des lentilles 2a, 2b, 2c, 2d aérodynamiques. Dans le mode de réalisation représenté sur les figures, la chambre 15 d'expansion comprend quatre lentilles 2a, 2b, 2c, 2d aérodynamiques réparties deux à deux entre une première colonne 9 et une deuxième colonne 10. Ainsi, les moyens 2a, 2b, 2c, 2d de production sont agencés de sorte à former au moins deux colonnes 9, 10 adjacentes ainsi qu'illustré sur la figure 1. La première colonne 9 comprend au moins un moyen 2a, 2c de production et la deuxième colonne 10 comprend au moins un moyen 2b, 2d de production.

Ledit au moins un moyen 2a, 2c de production de la première colonne 9 est décalé par rapport audit au moins un moyen 2b, 2d de production de la deuxième colonne 10 selon l'axe Y. Ledit au moins un moyen 2a, 2c de production de la première colonne 9 est décalé par rapport audit au moins un moyen 2b, 2d de production de la deuxième colonne 10 selon l'axe Z.

Le dispositif 1 comprend également une chambre 5 de dépôt logeant le substrat 4 sur lequel les particules de taille nanométrique sont destinées à être déposées. La chambre 5 de dépôt comporte au moins un système 6a, 6b de dépôt d'une matrice apte à enrober les particules nanométriques sur le substrat 4.

Dans une variante de réalisation non représentée sur les figures, la chambre 5 de dépôt ne comporte pas de système de dépôt d'une matrice. Dans ce cas aucun dépôt de matrice n'est réalisé sur le substrat et seules les particules nanométriques sont déposées sur le substrat. La matrice permet de modifier les propriétés du dépôt.

Le dispositif 1 comprend aussi un moyen 7 de préhension du substrat 4, apte à déplacer le substrat 4 selon la deuxième direction (Y). L'intérêt de ce moyen de préhension sera expliqué par la suite.

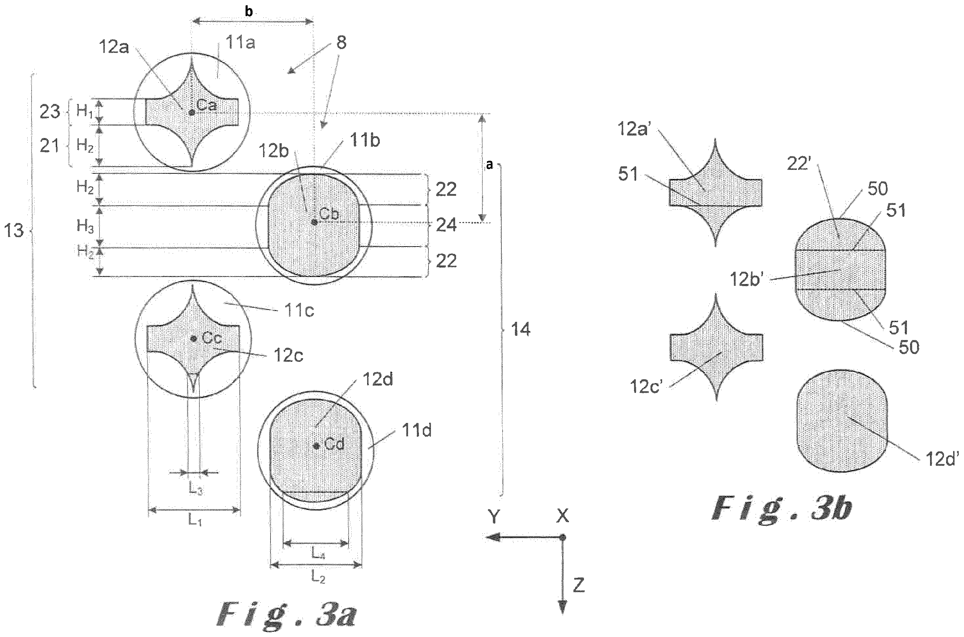

Le dispositif 1 comprend en outre une pluralité de masques 11, 11a, 11b, 11c, 11d, avantageusement situés dans la chambre de dépôt 5. Chaque masque 11, 11a, 11b, 11c, 11d définit une ouverture 12, 12a, 12b, 12c, 12d. Chaque masque 11, 11a, 11b, 11c, 11d est respectivement agencé en regard, selon la première direction (X) correspondant à la direction de propagation de chaque jet 3, d'un moyen 2a, 2b, 2c, 2d de production sur le trajet du jet 3 de particules. Ainsi, les masques sont également agencés selon une première colonne 13 et une deuxième colonne 14, selon un décalage similaire à celui des moyens de productions 2a, 2b, 2c, 2d. Le décalage des masques est particulièrement visible sur les figures 3a, 4a et 6a.

L'ouverture 12a, 12c d'un masque 11a, 11c de la première colonne 13 définit une première empreinte. L'ouverture 12b, 12d d'un masque 11b, 11d de la deuxième colonne 14 définit une deuxième empreinte, identique ou différente, de la première empreinte. Les empreintes de la première colonne 13 sont toutes identiques. Les empreintes de la deuxième colonne 14 sont toutes identiques.

On comprend que les masques 11, 11a, 11b, 11c, 11d sont situés entre le moyen de production 2a, 2b, 2c, 2d correspondant et le substrat 4.

Les masques permettent de modifier le profil spatial du jet 3 de particules et contribuent à l'obtention d'un revêtement homogène sur de grandes surfaces. Les masques 11, 11a, 11b, 11c, 11d ne laissent passer que la partie centrale du jet 3 de particules et filtrent les bords.

La chambre 5 de dépôt communique avec la chambre 15 d'expansion via des écorceurs 16. Le dispositif 1 comporte autant d'écorceurs 16 que de moyen de production 2a, 2b, 2c, 2d. Les écorceurs 16 se situent sur le trajet des jets 3 de particules. Les écorceurs 16 se présentent sous la forme d'ouvertures qui permettent d'isoler la chambre 15 d'expansion de la chambre 5 de dépôt d'un point de vue de la pression qui règne dans ces deux chambres 5, 15. Le diamètre des écorceurs 16 est variable et peut être ajusté en fonction du demi-angle de divergence des jets 3 de particules. Les écorceurs 16 laissent passer l'intégralité des nanoparticules tout en limitant drastiquement la quantité de gaz transmise de la chambre 15 d'expansion vers la chambre 5 de dépôt. Ainsi, une pression suffisamment basse peut être maintenue dans la chambre 5 de dépôt pour garantir l'intégrité du jet 3, qui dans la chambre de dépôt comporte essentiellement des particules, jusqu'au substrat 4 à des pressions compatibles avec le fonctionnement du système 6a, 6b de dépôt.

La chambre 5 de dépôt comprend les moyens 7 de préhension ou porte-substrat 7, aptes à déplacer le substrat 4. Le porte-substrat 7 peut se présenter sous diverses formes selon que l'on souhaite effectuer le dépôt sur un substrat 4 souple, par exemple en rouleau comme utilisé dans l'industrie, ou encore sur un substrat 4 rigide.

Le substrat 4 peut être chauffé et/ou polarisé afin d'obtenir des revêtements plus denses ayant de meilleures propriétés mécaniques tel que la dureté. A cet effet, le dispositif 1 peut comporter des moyens de chauffage et/ou de polarisation du substrat (non représentés).

Avantageusement, le ou chaque système 6a, 6b de dépôt est une cathode magnétron. Lorsque, avantageusement, plusieurs systèmes 6a, 6b de dépôt sont prévus, ils sont disposés de manière symétrique par rapport à l'axe X pour améliorer l'homogénéité du dépôt de la matrice. Sur les figures annexées, la chambre 5 de dépôt comporte d'ailleurs deux cathodes 6a, 6b magnétron. Toutefois ce chiffre peut être supérieur en fonction de l'étendue de la surface à revêtir.

Les cathodes 6a, 6b magnétron permettent le recouvrement du substrat par une matrice en même temps que les particules, cette matrice étant destinée à enrober les particules. Ainsi que l'on peut le voir sur les figures 1 et 2, un profil spatial 17 de projection de la matrice par les cathodes 6a, 6b magnétron recouvre les jets 3 de nanoparticules. Afin de garantir une épaisseur constante du dépôt de la matrice dans différentes conditions de dépôt (pression, matériau déposé, type d'alimentation utilisée et puissance de l'alimentation utilisée), la position des cathodes 6a, 6b magnétron est avantageusement réglable. On peut par exemple régler la distance entre un système de dépôt et le substrat. Cette distance pourra être typiquement réglée entre 5cm et 20cm. On peut aussi régler l'angle de dépôt de la matrice par rapport au substrat (qui est plan). Ainsi, cet angle peut être ajustée de sorte à être compris entre 45° et 80°.

La chambre 5 de dépôt comprend avantageusement des dispositifs 18 de caractérisation *in situ*. Ces dispositifs 18 sont visibles sur la figure 2. Avantageusement ces dispositifs 18 utilisent l'ellipsométrie spectrale. Ils permettent de suivre en temps réel et à différents endroits les propriétés optiques du dépôt effectué.

Le dispositif 1 comprend des moyens 19, 20 de pompage aptes à créer un vide dans la chambre 15 d'expansion et dans la chambre 5 de dépôt, respectivement. Des premiers moyens 20 de pompage sont aptes à créer un vide dont la pression est de l'ordre de $5.10^{-3}$ mbar dans la chambre 5 de dépôt lorsque le dispositif 1 fonctionne et de l'ordre de $10^{-5}$ mbar en absence de jet, c'est-à-dire lorsque le dispositif 1 ne fonctionne pas. Une pression inférieure à $5.10^{-2}$ en fonctionnement est souhaitable pour garantir l'intégrité du trajet des particules à travers la chambre 5 de dépôt. Des second moyens 19 de pompage sont aptes à créer un vide de l'ordre de 1 mbar dans la chambre 15 d'expansion. Les moyens 19 de pompage peuvent être des pompes, par exemple du type roots multiétagés. Les moyens 20 de pompage peuvent être des pompes, par exemple du type turbomoléculaires ou du type roots.

Dans ce qui suit, nous allons préciser les conditions d'obtention d'un revêtement homogène sur une grande surface, en référence aux figures 3 à 7.

Dans ce but, la disposition des masques n'est pas aléatoire.

Nous avons déjà fait remarquer que chaque masque 11a, 11b, 11c, 11d était en correspondance, donc en particulier sous la forme de deux colonnes comportant chacune au moins un masque avec un certain décalage selon les directions Y et Z, d'un moyen de production 2a, 2b, 2c, 2d sur le parcours d'un jet 3 de particules (axe X). Ceci est une condition pour obtenir un dépôt homogène des particules de taille nanométrique sur le substrat.

D'autres conditions relatives à l'agencement des masques, ainsi qu'à la forme des ouvertures de ces masques, sont importantes pour obtenir un dépôt homogène sur le substrat 4.

Nous allons tout d'abord définir un certain nombre de paramètres géométriques relatifs à l'agencement des masques ainsi qu'aux ouvertures de ces masques.

Les masques 11, 11a, 11b, 11c, 11d sont séparés d'une distance d de l'extrémité 60a, 60b, 60c, 60d du moyen de production correspondant, prise selon la première direction X. Les masques 11, 11a, 11b, 11c, 11d sont par ailleurs séparés d'une distance $d_2$ du substrat 4, prise selon la première direction X.

Le jet 3 issu de chaque moyen de production 2a, 2b, 2c, 2d est un jet divergent. Cela implique que le profil spatial de jet s'étend au fur et à mesure que l'on s'éloigne de l'extrémité 60a, 60b, 60c, 60d du moyen de production correspondant. On comprend donc que le positionnement des masques entre les moyens de production et le masque est important. Plus précisément, on peut définir un rapport d'homothétie permettant de relier le rapport entre les dimensions du dépôt, sur le substrat 4, provenant d'un masque, et les dimensions des ouvertures 12a, 12b, 12c, 12d des masques (facteur d'homothétie). Ce facteur d'homothétie s'exprime comme suit :

$$f = \frac{d_1}{d_1 + d_2}$$

Ce facteur d'homothétie f est le même pour l'ensemble des masques et on comprend donc, comme cela est d'ailleurs visible sur les figures annexées que tous les masques sont situés dans un même plan, en l'occurrence le plan YZ (figure 2 par exemple).

La distance $d_1$ introduite ci-dessus peut correspondre à la distance d entre l'extrémité 60a, 60b, 60c, 60d et le plan dans lequel les masques 11, 11a, 11b, 11c, 11d sont situés. Cependant, il convient de noter que, notamment dans le cas d'une lentille aérodynamique, le jet 3 issu de cette lentille aérodynamique est généralement d'abord convergent puis divergent. La distance $d_1$ est donc la distance entre le point P de divergence du jet 3 ( = point P de passage de la convergence à la divergence du jet 3) et le plan dans lequel les masques 11, 11a, 11b, 11c, 11d sont situés. Nous reviendrons ultérieurement sur cet aspect.

Le demi-angle $\alpha$ de divergence du jet 3 est donc défini à partir de ce point P de divergence.

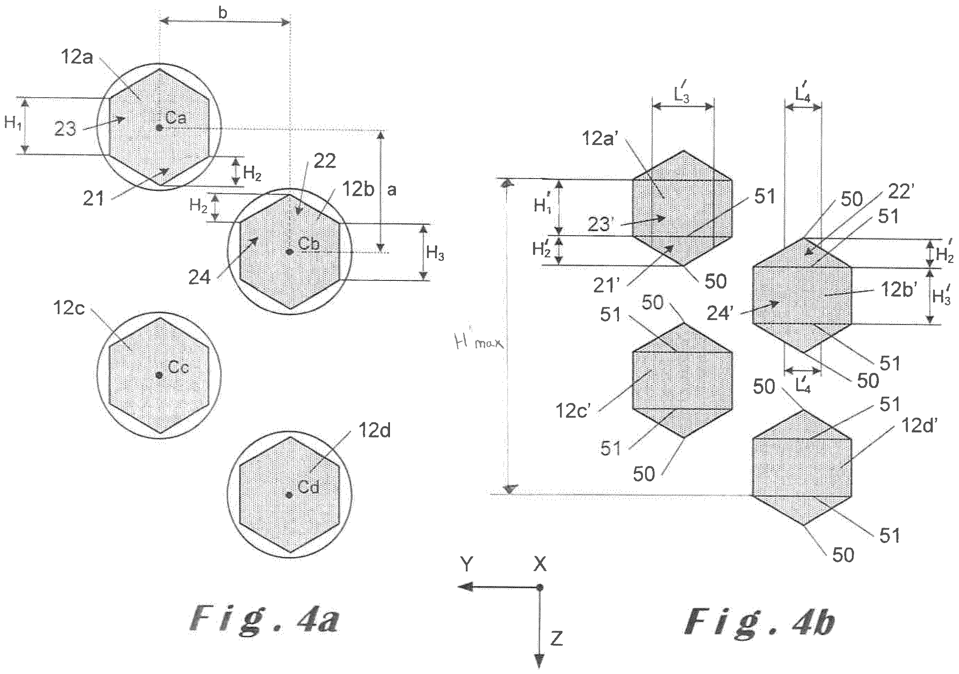

Par ailleurs, chaque ouverture 12a, 12b, 12c, 12d est munie d'un centre Ca, Cb, Cc, Cd, les centres Ca, Cb ; Cc, Cd de deux ouvertures les plus proches et appartenant à des colonnes 13, 14 différentes de masques étant séparées d'une distance a selon la troisième direction Z et d'une distance b selon la deuxième direction Y (cf. figure 3a ou 4a, par exemple).

Comme cela a été indiqué précédemment, l'axe de propagation d'un jet 3 de particules est défini par la première direction X, laquelle se confond avec l'axe longitudinal du moyen de production ayant produit ce jet 3. Le placement des masques 11a, 11b, 11c, 11d est effectué de sorte que l'axe de propagation du jet 3, et ce pour chaque jet issu d'un moyen de production, passe par le centre Ca, Cb, Cc, Cd de l'ouverture du masque associé audit moyen de production. Cela revient à dire que l'axe longitudinal d'un moyen de production passe par le centre de l'ouverture du masque associé.

L'ouverture 12a, 12c dudit au moins un masque de la première colonne 13 de masques définit :

- une première portion 23, centrale, dont la largeur $L_1$, définie selon la deuxième direction Y, est constante, et dont la hauteur $H_1$, définie selon la troisième direction Z, est également constante,
- une deuxième portion 21, dont la largeur $L_3$, définie selon la deuxième direction Y, est variable selon la troisième direction Z,

L'ouverture 12b, 12d dudit au moins un masque de la deuxième colonne 13 de masques définit :

- une troisième portion 24, centrale, dont la largeur $L_2$, définie selon la deuxième direction Y, est constante et dont la hauteur $H_3$, définie selon la troisième direction Z, est également constante, et
- une quatrième portion 22, dont la largeur $L_4$, définie selon la deuxième direction (Y), est variable selon la troisième direction (Z).

Compte tenu des paramètres définis ci-dessus, les conditions additionnelles pour obtenir un dépôt homogène sont les suivantes.

Afin que les particules traversent l'ensemble de l'ouverture, il convient que l'ouverture du masque soit inscriptible dans un cercle de diamètre $D'_j$ :

$$D'_j = 2d_1 \sin\alpha$$

et avantageusement qu'il soit inscriptible dans un cercle de diamètre strictement inférieur (légèrement) à $D'_j$ , pour éviter les effets de bord sur l'ouverture du masque.

D'autres conditions sont les suivantes :

La largeur $L_1$ est égale à la largeur $L_2$.
La relation suivante est vérifiée :

$$b \geq \frac{1}{f}\frac{L_1}{2}$$

Les deux conditions mentionnées ci-dessus, relatives aux masques et à leurs ouvertures, permettent d'éviter un recouvrement des dépôts entre les deux masques les plus proches de deux colonnes 13, 14 différentes de masques.

En outre, toujours compte tenu des paramètres définis ci-dessus, les conditions additionnelles suivantes doivent également être respectées :

La deuxième portion 21 et la quatrième portion 22 sont situées entre lesdites première portion 23 et troisième portion 24. De plus, la deuxième portion 21 et la quatrième portion 22 présentent une hauteur maximale identique, définie selon la troisième direction Z, nommée $H_2$.

Et, la relation suivante est vérifiée :

$$a = \frac{1}{f}\left(\frac{H_1}{2} + H_2 + \frac{H_3}{2}\right)$$

Les deux conditions mentionnées ci-dessus assurent que, au niveau du substrat 4, la deuxième portion 21' du dépôt (correspondant à la deuxième portion 21 de l'ouverture correspondante du masque compte tenu du facteur d'homothétie f) et la quatrième portion 22' du dépôt (correspondant à la quatrième portion 22 de l'ouverture correspondante du masque compte tenu du facteur d'homothétie f) ont, bien entendu, une même hauteur maximale H'$_2$ (effet du facteur d'homothétie f), mais aussi soient en correspondance, c'est-à-dire, s'étendent sur une même gamme de valeurs de la cote selon la troisième direction Z (cf. figure 3b ou figure 4b).

Une condition additionnelle est que la somme S = $L_3$ + $L_4$ des largeurs variables selon la troisième direction de la deuxième portion 21 et de la quatrième portion 22 desdits masques, lorsque ces derniers sont mis en vis-à-vis selon la troisième direction Z, est constante et égale à $L_1$. D'un point de vue pratique, et pour vérifier cet aspect, en l'occurrence lorsque les masques ne se présentent pas sur une pièce commune, on peut prendre le masque 11a (première colonne 13) et le masque 12a (deuxième colonne 14) et disposer les portions 21, 22 en parfaite correspondance.

On s'assure ainsi en plus, sur cette partie du dépôt sur le substrat 4 que, lorsque le moyen de préhension 7 est mis en œuvre pour assurer un déplacement selon la deuxième direction Y, l'association des dépôts concernant les portions 21', 22' aura le même effet que le dépôt réalisé grâce aux portions 23, 24 de dimensions constantes des masques.

La figure 4b illustre le dépôt obtenu sur le substrat 4 à un instant prédéterminé à partir de l'agencement des masques 11a, 11b, 11c, 11d illustré sur la figure 4a. Les formes 12a', 12b', 12c', 12d' sont sensiblement identiques aux ouvertures 12a, 12b, 12c, 12d mais diffèrent de par leurs dimensions (facteur d'homothétie f).

Ainsi qu'on peut le voir sur la figure 4b, le dépôt comporte une première portion 21' et une deuxième portion 22'. En comparaison avec les portions 21, 22 de la figure 4a, les portions 21', 22' de la figure 4b sont en correspondance selon la troisième direction Z (pas de décalage).

Les largeurs L'$_1$, L'$_2$, L'$_3$ et L'$_4$ des dépôts sont respectivement égales aux largeurs $L_1$, $L_2$, $L_3$ et $L_4$ au facteur d'homothétie f près. Les hauteurs H'$_1$, H'$_2$ et H'$_3$ des dépôts sont respectivement égales aux hauteurs $H_1$, $H_2$ et $H_3$ des masques au facteur d'homothétie f près.

On peut aussi relever les aspects suivants.

Les dépôts 12a', 12b', 12c', 12d' obtenus comprennent les caractéristiques suivantes :

- une extrémité 50 se situe au même niveau, selon l'axe Z, qu'une frontière 51 située à l'intérieur de la forme 12a', 12b', 12c', 12d'. La frontière 51 marque la fin de la portion 21', 22', c'est-à-dire le point où la longueur L'$_3$, L'$_4$ ne varie plus selon que l'on se déplace selon l'axe Z ; et

- la somme S de la troisième largeur L'$_3$ et de la quatrième largeur L'$_4$ est en tout point de l'axe Z égale (ou sensiblement égale) à la première largeur L'$_1$ et à la deuxième largeur L'$_2$.

La frontière 51 marque la jonction entre les portions 21, 23 et entre les portions 22, 24.

On notera que dans la mesure où l'axe de propagation d'un jet 3 de particules de taille nanométrique passe par le centre Ca, Cb, Cc, Cd correspondant d'une ouverture de masque, la distance a, comme la distance b sont inchangées lorsqu'elles sont mesurées au niveau du masque ou au niveau du dépôt réalisé sur le substrat 4.

Il convient de noter que si le fait d'employer plusieurs masques permet déjà d'obtenir des dépôts sur une surface importante, le fait que le substrat 4 puisse être déplacé selon la deuxième direction Y permet d'atteindre des dépôts sur de grandes surfaces, tout en conservant une homogénéité du dépôt. Cela implique un dépôt dont l'épaisseur est sensiblement constante.

Différentes formes de masques et en conséquence d'ouvertures peuvent être envisagées.

Sur la figure 4a, on a ainsi représenté des masques dont l'ouverture présente une forme hexagonale.

Cette forme hexagonale peut notamment être régulière lorsque tous les côtés de l'hexagone présentent une longueur identique. C'est d'ailleurs le cas sur la figure 4a (ce qui implique notamment $H_1 = H_3$).

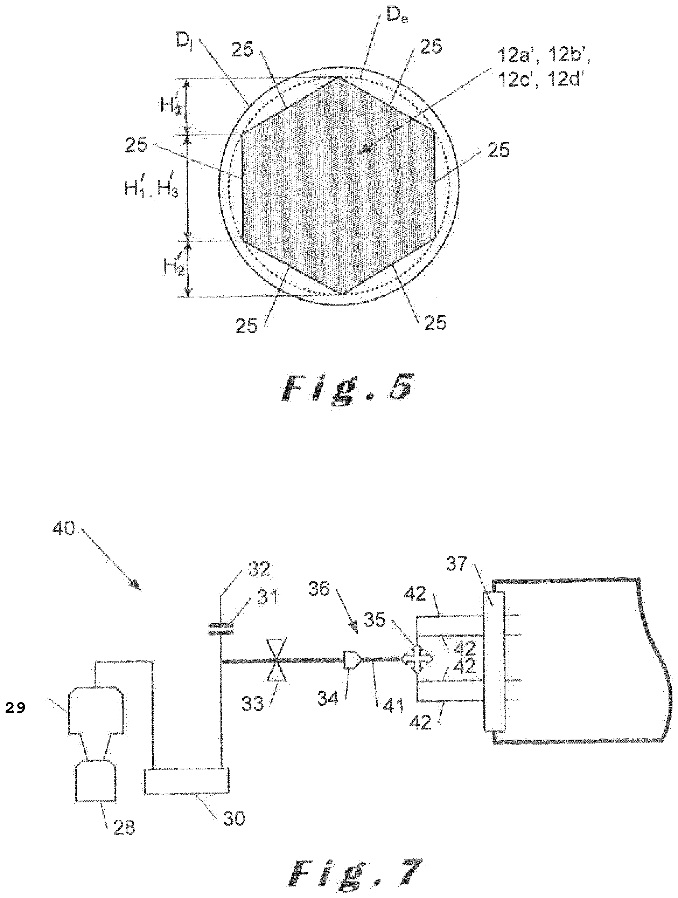

En référence à la figure 5 qui illustre un dépôt obtenu (test expérimental) au moyen d'un masque de la figure 4a, la forme 12a' obtenue présente une forme hexagonale régulière plus grande que l'ouverture 12a. Cette forme symétrique est comprise dans un cercle de rayon $D_e$. Les côtés 25 de l'hexagone régulier ont donc la même longueur et les angles entre chacun desdits côtés 25 valent sensiblement 120°.

Dans ce cas particulier de l'hexagone régulier, on peut relever que :

- $H'_1 = H'_3 = De / 2$
- $H'_2 = De / 4$

Il en résulte qu'une hauteur $H'_{max}$ couverte par un revêtement homogène est calculée à l'aide de la formule suivante :

$$H'_{max} = \frac{1}{4}(3n - 1)D_e$$

où n est le nombre de masques 11a, 11b, 11c, 11d et également le nombre de moyens de production 2a, 2b, 2c, 2d.

Pour $D_e$ = 36,8 mm, la hauteur du revêtement vaut 101,2 mm avec 4 masques (n = 4), ces masques étant en l'occurrence tous identiques. Cette hauteur $H'_{max}$ a été représentée sur la figure 4b.

En l'absence de masque, et compte tenu de la divergence du jet, le dépôt réalisé à partir d'un et d'un seul moyen de production 2a serait de forme circulaire. Le diamètre $Dj$ du dépôt associé à ce moyen de production est alors défini par :

$$D_j = 2(d_1 + d_2)\sin\alpha$$

où a est, pour rappel, le demi-angle de divergence du jet 3.

Pour ce test, on a choisi $D_e = 0,9.D_j$, pour éviter les effet de bord au niveau du masque. Dans l'exemple considéré, cela donne une valeur de $D_j \approx 40,89$mm.

Ainsi le dépôt homogène couvre une surface d'une hauteur d'environ 10 cm sur le substrat 4.

Ce test a été réalisé avec des particules de tailles nanométrique en Or (Au).

La dimension selon l'axe Y dépend alors de l'amplitude du mouvement du substrat 4. Dans le cas d'un substrat 4 souple sous forme de rouleau, il est possible de couvrir de façon homogène d'importantes surfaces.

Dans le cadre de ce test, il a été choisi, de prendre les valeurs théoriques suivantes :

$d_{th}$ = 164 mm,
$d_{2,th}$ = 128 mm,
ce qui implique $f_{th}= d_{th}/(d_{2,th} + d_{th}) \approx 0,5616$ (facteur d'homothétie théorique, celui qui est voulu).

Pour une application à des particules d'or de 10 nm, on a pu constater (expérimentalement) que $d_{1,th}$ = $d_{th}$ - 4 mm = 160 mm. Le véritable facteur d'homothétie (pris à partir du point P de divergence du jet 3, tel que défini précédemment) est alors $d_{1,th}/(d_{2,th} + d_{1,th}) \approx 0,5556$.

Si on juge que la différence entre le véritable facteur d'homothétie et le facteur d'homothétie théorique est significative, cela implique de devoir faire un ajustement des distances d, $d_1$ et $d_2$ sur le dispositif de manière à retrouver le facteur d'homothétie théorique.

En pratique, la distance d + $d_2$ est constante, tout comme la distance $d_1$ + $d_2$.

L'ajustement (lorsqu'il est jugé nécessaire) se fait en translatant les masques, selon la première direction X, ce qui implique de changer les distances d, $d_1$ et $d_2$ sans changer la somme d + $d_2$ (sans changer également la somme $d_1$ + $d_2$).

Lors de cet ajustement, $d_{th}$ devient donc d, $d_{1,th}$ devient $d_1$ et $d_{2,th}$ devient $d_2$, avec $d_{th}+d_{2,th}$ = d + $d_2$ (et aussi $d_{1,th}+d_{2,th}$ = $d_1+d_2$). Dans cet ajustement, il faut aussi retrouver le facteur d'homothétie théorique (celui qui est voulu), d'où la relation $f_{th}$ = $d_{th}/(d_{th} + d_{2,th})$ = $d_1/(d_1 + d_2)$.

Il vient alors:

$$d_1 = d_{th}[1-(d_{th}-d_{1,th})/(d_{th}+d_{2,th})] \quad (R_a)$$

et:

$$d_2 = d_{2,th} + d_{1,th} - d_1 \quad (R_b)$$

On peut alors régler expérimentalement la distance d = $d_{th}$ - $d_{1,th}$ + $d_1$ ($R_c$).

Si on prend l'exemple précédent avec les nanoparticules d'or de 10 nm, on a $d_{th}$ - $d_{1,th}$ = 4 mm, et on obtient alors $d_1$ = 161,75 mm et $d_2$ = 126,25 mm (on peut au passage vérifier que $d_1$ + $d_2$ = 288 mm = $d_{1,th}$ + $d_{2,th}$.)

Il n'y a plus qu'à régler physiquement la distance d = $d_1$ + $d_{th}$ - $d_{1,th}$ = 161,75 + 4 = 165,75 mm (on peut vérifier que $d_{th}/(d_{th}+d_{2,th})$ = $d_1/(d_1+d_2) \approx 0,5616$).

Le véritable facteur d'homothétie, ajusté, à savoir la quantité f = $d_1/(d_1 + d_2)$ est maintenant celui qu'on voulait théoriquement. C'est bien ce véritable facteur d'homothétie, ajusté, qui est mentionné dans les revendications annexées.

Bien entendu, lorsque l'on constate (expérimentalement) que $d_{th} = d_{1,th}$, aucun ajustement n'est nécessaire. Dans ce cas, $d = d_{th}$, $d_1 = d_{th}$ et en conséquence $d_2 = d_{2,th}$ (cas particulier des relations $(R_a)$, $(R_b)$ et $(R_c)$ ci-dessus).

La valeur de $d = 165,75$ mm est proche de $d_{th} = 164$ mm, ce qui implique que $d$ est proche de $d_1$. Cependant, dans la pratique, cette proximité peut malgré tout avoir un impact significatif sur le résultat (homogénéité) du dépôt. D'un point de vue théorique, la distance $d - d_1$ $(= d_{th} - d_{1,th})$ n'est pas connue. Des simulations numériques peuvent donner une idée de cette distance $d - d_1$, mais on constate généralement qu'il existe une différence non négligeable par rapport à ce qui peut être mesuré expérimentalement. En conséquence, en pratique, l'ajustement s'effectue expérimentalement par approximations successives. Cet ajustement expérimental est par ailleurs efficace, dans la mesure où la distance $d - d_1$ dépend fortement de la nature des particules employées. Ainsi et par exemple, pour des particules de silicium de 50 nm, on a pu constater que $d - d_1 = 2$ mm.

Au final, toujours pour ce test, on a donc $f \approx 0,5616$ avec $d_1 = 161,75$mm et $d_2 = 126,5$mm et le diamètre De, vaut : De $\approx 36,8$mm. Ce diamètre De peut aussi s'exprimer sous la forme De $= (1/f)*(H_1 + 2H_2)$, cf. figure 5 où l'on note que De $= H'_1 + 2H'_2$ et dans la mesure où $H'_1 = (1/f)H_1$ et $H'_2 = (1/f)H_2$. Par ailleurs, du fait de la géométrie de l'hexagone régulier, il est possible de faire un lien entre $H_2$ et $H_1$, à savoir $H_2 = H_1\sin(\pi/6)$. On en déduit $H_1 \approx 10,33$mm (tous les côtés de l'hexagone régulier ont la même valeur) et $H_2 \approx 5,17$mm. Par ailleurs, toujours du fait de la forme d'hexagone régulier, on en déduit $L_1 = 2H_1\cos(\pi/6) \approx 17,89$mm $= L_2$. Par ailleurs, de la relation entre $D_j$ et le demi-angle du jet 3, on en déduit $\sin(\alpha) \approx 40,89/(2*288) \approx 0,071$ ce qui nous donne un demi-angle $\alpha$ de divergence du jet 3 d'un peu plus de 4°. La valeur de la distance a peut aussi être estimée à a $\approx 27,6$ mm par l'équation mentionnée précédemment. Dans ce test, il suffit par ailleurs que $b \geq 15,93$mm pour éviter tout recouvrement.

Des empreintes de forme hexagonale régulière présentent plusieurs avantages. Elles permettent un motif identique sur les colonnes de lentilles. Elles sont relativement faciles à réaliser et permettent de filtrer un minimum de particules car la surface des ouvertures 12a, 12b, 12c, 12d est maximisée. Ceci permet une vitesse globale de dépôt de particules élevée.

Une autre forme est représenté sur les figures 3a et 3b. Ici, les masques 11a, 11c présentent une empreinte différente des masques 11b, 11d. Les caractéristiques inhérentes aux hauteurs $H_1$, $H_2$, $H_3$ et aux largeurs $L_1$, $L_2$, $L_3$ et $L_4$ précédemment évoquées, s'appliquent aussi à ce mode de réalisation.

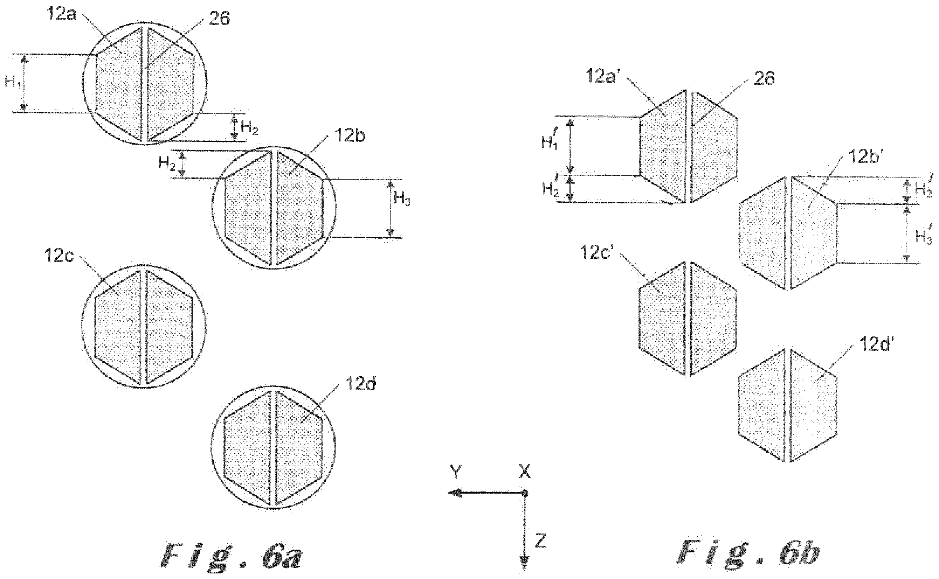

Encore une autre forme des masques 11a, 11b, 11c, 11d est illustrée sur la figure 6a. Sur cette figure, l'empreinte du masque 11a, 11b, 11c, 11d est séparée en deux par une bande 26 centrale qui s'étend selon l'axe Z. L'empreinte forme ainsi deux trapèzes 39 isocèles. Les caractéristiques inhérentes aux largeurs $H_1$, $H_2$, $H_3$ et aux largeurs $L_1$, $L_2$, $L_3$ et $L_4$ précédemment évoquées, s'appliquent aussi à ce mode de réalisation. La bande 26 permet avantageusement de filtrer une zone centrale du jet 3 de particules. En effet, dans certains cas, les particules peuvent présenter une distribution de taille faisant apparaître des nanoparticules de grande taille en raison d'une agglomération partielle des particules. Le comportement aérodynamique des particules agglomérées est différent de celui des particules non agglomérées. Notamment, leur angle de divergence est très inférieur à celui des particules non agglomérées. Il en résulte, dans ce cas, une distribution spatiale du jet 3 de particules inhomogène concentrée au centre du jet 3 provoquant une forte surintensité à cet endroit. La bande 26 permet ainsi de filtrer la partie centrale du jet 3 de particules.

L'empreinte est formée sur la base de l'hexagone du mode de réalisation des figures 4a et 5. On remarquera que l'hexagone n'est plus strictement régulier. Il a été légèrement allongé selon l'axe Z de sorte que les sommets 27 haut et bas coïncident avec le cercle de rayon $D_e$. Ainsi la dimension selon l'axe Z couverte par le revêtement reste inchangée par rapport au masque des figures 4a et 5. La seule différence réside dans le fait que la vitesse de dépôt s'en trouvera légèrement diminuée.

Dans sa généralité, l'invention est mise en œuvre avec un masque par colonne 13, 14.

Bien entendu, et comme cela est d'ailleurs représenté sur les figures 3a ou 4a, il est avantageux de prévoir plusieurs masques par colonne 13, 14. Dans ce cas, on comprend d'une part que les masques, et notamment leurs ouvertures, de la première colonne 13 sont identiques et d'autre part que les masques, et notamment leurs ouvertures, de la deuxième colonne 14 sont également identiques. Les masques et les ouvertures associées de la deuxième colonne et de la première colonne peuvent alors être identiques (Fig. 4a) ou différentes (Fig. 3a). On comprend toutefois que, si l'on prend par exemple le mode de réalisation de la fig. 3a, le masque 11c (première colonne 13, deuxième masque) et le masque 11d (deuxième colonne 14, deuxième masque) sont agencés entre eux, de la même façon que le sont les masques 11a (première colonne 13, premier masque) et 11b (deuxième colonne 14, premier masque). Par ailleurs, le masque 11c (première colonne 13, deuxième masque) présente un agencement, vis-à-vis du masque 11b (deuxième colonne 14, premier masque) identique à l'agencement qui est prévu entre les masques 1 la et 11b.

Sur la figure 7, est représenté un système 40 d'acheminement des particules avant que celles-ci n'arrivent dans les moyens de production 2a, 2b, 2c, 2d.

Le système 40 d'acheminement comprend :

- une suspension 28 colloïdale,
- un générateur 29 d'aérosols à partir de la suspension 28 colloïdale,
- éventuellement un sécheur 30 pour sécher les aérosols,
- un filtre 31 (optionnel),
- une évacuation 32,
- une vanne 33 apte à ouvrir ou fermer le flux d'aérosols vers les moyens 2a, 2b, 2c, 2d, en l'occurrence des lentilles aérodynamiques,
- un orifice 34 critique,
- une séparateur 35 de flux,
- un volume 36 tampon situé entre l'orifice 34 critique et le séparateur 35 de flux, et
- une bride 37 de distribution vers les lentilles 2a, 2b, 2c, 2d aérodynamiques.

Les particules sont générées, via le générateur 29 depuis la suspension 28 colloïdale dont un solvant peut être par exemple de l'eau. Lorsque l'eau est utilisée comme solvant, le système 40 d'acheminement comprend un sécheur 30 à travers lequel passent les aérosols produits via le générateur 29 d'aérosols. En capturant les molécules d'eau, le sécheur 30 permet aux gouttelettes produites par le générateur d'aérosols de s'évaporer rapidement, et donc de fournir à sa sortie des aérosols secs portés par un gaz porteur exempt de molécules de solvant.

Lorsque la vanne 33 est ouverte, une partie du flux d'aérosols est acheminée vers l'orifice 34 critique dont le diamètre détermine le débit volumique orienté vers les lentilles 2a, 2b, 2c, 2d aérodynamiques. Le débit en sortie du générateur 29 d'aérosols est compris entre 2 et 3 slm (litre standard par minute). Chaque lentille 2a, 2b, 2c, 2d aérodynamique a besoin d'un débit de l'ordre de 0,15 slm pour une lentille divergente de géométrie standard.

Le débit non utilisé par les lentilles 2a, 2b, 2c, 2d aérodynamiques est envoyé vers l'évacuation 32. Le diamètre de l'orifice 34 critique est déterminé en fonction du nombre de lentilles 2a, 2b, 2c, 2d aérodynamiques à alimenter. Ce diamètre est compris entre 350 microns et 550 microns pour quatre lentilles 2a, 2b, 2c, 2d aérodynamiques et avec de l'argon comme gaz porteur.

L'utilisation d'un seul orifice 34 critique placé avant le séparateur 35 de flux présente l'avantage d'améliorer la robustesse du système 40 d'acheminement car l'orifice 34 critique est moins susceptible de se boucher. En effet, en variante, plusieurs orifices critiques pourraient être utilisés, par exemple un pour chaque lentille 2a, 2b, 2c, 2d aérodynamique. Dans ce cas, les orifices critiques présentent un diamètre inférieur, de l'ordre de 200 μm avec de l'argon comme gaz porteur, et peuvent se boucher plus facilement.

Afin de répartir de manière égale le flux d'aérosols dans les lentilles 2a, 2b, 2c, 2d aérodynamiques, il est préférable que les canalisations conduisant les aérosols du séparateur de flux jusqu'aux lentilles 2a, 2b, 2c, 2d aérodynamiques aient les mêmes dimensions, et que le volume compris entre l'orifice 34 critique et le séparateur 35 de flux soit rendu minimal. Ceci permet d'éviter qu'une dispersion inhomogène ait le temps de se mettre en place entre l'orifice 34 critique et le séparateur 35 de flux. Avantageusement, ce volume est inférieur à 10 cm$^3$.

Avantageusement, une canalisation 41 entre l'orifice 34 critique et le séparateur 35 de flux est rigide et peut se présenter sous la forme d'un tube, par exemple de diamètre intérieur de 8 mm et de longueur de 5 cm, ce qui donne un volume d'environ 2,5 cm3.

Une distribution spatiale homogène des particules dans les différents volumes des canalisations 42, contribue à l'homogénéité des revêtements. Afin d'améliorer cette distribution spatiale, des canalisations 42 entre le séparateur 35 de flux et la bride 37 de distribution aux lentilles 2a, 2b, 2c, 2d aérodynamiques sont avantageusement droites ou faiblement courbées. Compte tenu du débit volumique normalement utilisé dans une lentille aérodynamique divergente de géométrie standard (0,15 slm), les canalisations ne comportent avantageusement pas de courbures d'un rayon inférieur à 5 cm sur un arc supérieur à Pi/4 radians. L'invention est définie par les revendications.

## Revendications

1. Dispositif (1) de dépôt de particules de taille nanométrique sur un substrat (4) dans lequel le dispositif (1) comprend :

   - des moyens (2a, 2b, 2c, 2d) dits de production chacun apte à produire, à partir d'une extrémité (60a, 60b, 60c, 60d) des moyens de production (2a, 2b, 2c, 2d), un jet (3) de particules de taille nanométrique, chacun desdits moyens de production étant configuré pour présenter un axe longitudinal orienté dans une première direction (X) définissant un axe de propagation du jet (3), et configuré de sorte que le jet (3) est divergent à partir d'un point P de divergence avec un demi-angle de divergence α par rapport à son axe de propagation, les moyens de production étant agencés de sorte que les différents axes longitudinaux sont parallèles entre eux et sous la forme d'au moins une première colonne (9) et une deuxième colonne (10) décalées l'une par rapport à l'autre selon une deuxième direction (Y) orthogonale à la première direction (X) où la première colonne (9) et la deuxième colonne (10) comportent chacune au moins un moyen (2a, 2b, 2c, 2d) de production, ledit au moins un moyen (2a, 2b, 2c, 2d) de production de la première colonne (9) étant par ailleurs décalé par rapport audit au moins un moyen (2a, 2b, 2c, 2d) de production de la deuxième colonne (10) selon une troisième direction (Z) à la fois orthogonale à la première direction (X) et à la deuxième direction (Y),
- une chambre (15) d'expansion dans laquelle logent au moins chaque extrémité (60a, 60b, 60c, 60d) des moyens (2a, 2b, 2c, 2d) de production ;
- une chambre (5) de dépôt comportant :

• ledit substrat (4)
• un moyen (7) de préhension du substrat (4), apte à déplacer ledit substrat (4) dans la deuxième direction (Y)
• une pluralité de masques (11, 11a, 11b, 11c, 11d) comportant chacun une ouverture (12, 12a, 12b, 12c, 12d), chaque masque étant situé, selon la première direction (X) définissant la direction de propagation du jet, entre un moyen (2a, 2b, 2c, 2d) de production et le substrat (4) si bien que lesdits masques se présentent également sous la forme d'au moins une première colonne (13) et une deuxième colonne (14) décalées l'une par rapport à l'autre selon la deuxième direction (Y) où la première colonne (13) et la deuxième colonne (14) comportent chacune au moins un masque, ledit au moins un masque (11a, 11b) de la première colonne (13) étant par ailleurs décalé par rapport audit au moins un masque (11c, 11d) de la deuxième colonne (14) selon la troisième direction (Z), et si bien que, toujours selon la première direction (X) définissant la propagation du jet, les masques (11, 11a, 11b, 11c, 11d) sont séparés par une première distance $d_1$ du point P de divergence du jet (3) et par une deuxième distance $d_2$ du substrat (4) et chaque ouverture (12a, 12b, 12c, 12d) étant munie d'un centre (Ca, Cb, Cc, Cd) par lequel passe l'axe longitudinal du moyen de production associé, les centres (Ca, Cb ; Cc, Cd) de deux ouvertures les plus proches et appartenant à des colonnes (13, 14) différentes étant séparées d'une distance a selon la troisième direction (Z) et d'une distance b selon la deuxième direction (Y),

chaque ouverture (12a, 12b, 12C, 12d) d'un masque étant inscriptible dans un cercle de diamètre $2d_1 \sin\alpha$,
l'ouverture (12a, 12c) dudit au moins un masque de la première colonne (13) définissant :

- une première portion (23), centrale, dont la largeur $L_1$, définie selon la deuxième direction (Y), est constante, et dont la hauteur $H_1$, définie selon la troisième direction (Z), est également constante,
- une deuxième portion (21), dont la largeur $L_3$, définie selon la deuxième direction (Y), est variable selon la troisième direction (Z),

l'ouverture (12b, 12d) dudit au moins un masque de la deuxième colonne (14) définissant :

- une troisième portion (24), centrale, dont la largeur $L_2$, définie selon la deuxième direction (Y), est constante et égale à la largeur $L_1$, et dont la hauteur $H_3$, définie selon la troisième direction (Z), est également constante, et
- une quatrième portion (22), dont la largeur $L_4$, définie selon la deuxième direction (Y), est variable selon la troisième direction (Z),

lesdites deuxième portion (21) et quatrième portion (22) étant d'une part situées entre lesdites première portion (23) et troisième portion (24) et présentant d'autre part une hauteur maximale $H_2$, définie selon la troisième direction (Z), identique, la somme $S = L_3 + L_4$ des largeurs variables selon la troisième direction de la deuxième portion (21) et de la quatrième portion (22) desdits masques, lorsque ces derniers sont mis en vis-à-vis selon la troisième direction (Z), étant constante et égale à $L_1$, les relations suivantes étant en outre respectées :

$$a = \frac{1}{f}\left(\frac{H_1}{2} + H_2 + \frac{H_3}{2}\right) \quad \text{et} \quad b \geq \frac{1}{f}\frac{L_1}{2}$$

où :

$$f = \frac{d_1}{d_1 + d_2}$$

2. Dispositif selon la revendication 1 dans lequel l'ouverture (12a, 12c) dudit au moins un masque de la première colonne (13) et l'ouverture (12b, 12d) dudit au moins un masque de la deuxième colonne (14) ont des formes différentes.

3. Dispositif selon la revendication 1 dans lequel l'ouverture (12a, 12c) dudit au moins un masque de la première colonne (13) et l'ouverture (12b, 12d) dudit au moins un masque de la deuxième colonne (14) ont des formes identiques.

4. Dispositif (1) selon l'une des revendications précédentes, dans lequel l'ouverture (12a, 12c) dudit au moins un masque de la première colonne (13) et l'ouverture (12b, 12d) dudit au moins un masque de la deuxième colonne (14) présentent une forme hexagonale.

**5.** Dispositif (1) selon la revendication précédente dans lequel le masque comprend une bande (26) qui s'étend selon la troisième direction (Z) et séparant chaque ouverture en deux.

**6.** Dispositif (1) selon l'une des revendications précédentes, comprenant au moins un système de dépôt (6a, 6b) d'une matrice sur le substrat.

**7.** Dispositif (1) selon l'une des revendications précédentes comprenant une pluralité de systèmes (6a, 6b) de dépôt d'une matrice sur la substrat, lesdits systèmes (6a, 6b) de dépôt étant agencés de manière symétrique par rapport à la première direction (X).

**8.** Dispositif (1) selon l'une des revendications précédentes dans lequel la position du ou de chaque système (6a, 6b) de dépôt de la matrice sur le substrat est réglable, par exemple pour faire varier la distance entre ledit système et le substrat et/ou l'angle de dépôt de la matrice par rapport au substrat.

**9.** Ensemble comportant un dispositif (1) selon l'une des revendications précédentes et un système (40) d'acheminement de particules destiné à alimenter les moyens (2a, 2b, 2c, 2d) de production dudit dispositif (1), le système (40) comprenant des moyens (28, 29, 30, 31, 32, 33) aptes à générer un aérosol, un orifice (34) critique, un séparateur (35) de flux, une bride (37) de distribution aux moyens 2a, 2b, 2c, 2d) de production et un volume (36) tampon situé entre l'orifice (36) critique et le séparateur (35) de flux, système (40) dans lequel, l'orifice (36) critique est placé avant le séparateur (35) de flux.

**10.** Ensemble selon la revendication précédente dans lequel le volume du ou des canalisations (41) entre l'orifice (34) critique et le séparateur (35) de flux est inférieure ou égale à 10 cm3.

**11.** Ensemble selon l'une des revendications 9 ou 10 dans lequel des canalisations (42) entre le séparateur (35) de flux et la bride (37) de distribution sont droites ou faiblement courbées.

**Patentansprüche**

**1.** Vorrichtung (1) für die Ablagerung von Teilchen in Nanogröße auf einem Substrat (4), wobei die Vorrichtung (1) Folgendes umfasst:

Mittel (2a, 2b, 2c, 2d), die als Produktionsmittel bezeichnet werden und jeweils in der Lage sind, von einem Ende (60a, 60b, 60c, 60d) der Produktionsmittel (2a, 2b, 2c, 2d) einen Strahl (3) von Partikeln in Nanogröße zu erzeugen, wobei jedes der besagten Produktionsmittel so konfiguriert ist, dass es eine Längsachse aufweist, die in einer ersten Richtung (X) ausgerichtet ist, die eine Ausbreitungsachse des Strahls (3) definiert, und so konfiguriert ist, dass der Strahl (3) von einem Divergenzpunkt P mit einem halben Öffnungswinkel α in Bezug auf seine Ausbreitungsachse divergiert, wobei die Produktionsmittel so angeordnet sind, dass die verschiedenen Längsachsen parallel zueinander sind und die Form mindestens einer ersten Säule (9) und einer zweiten Säule (10) aufweisen, die in einer zweiten Richtung (Y) orthogonal zur ersten Richtung (X) gegeneinander versetzt sind, wobei die erste Säule (9) und die zweite Säule (10) jeweils mindestens ein Produktionsmittel (2a, 2b, 2c, 2d) umfassen, wobei das besagte mindestens eine Produktionsmittel (2a, 2b, 2c, 2d) der ersten Säule (9) außerdem in Bezug auf das besagte mindestens eine Produktionsmittel (2a, 2b, 2c, 2d) der zweiten Säule (10) in einer dritten Richtung (Z) versetzt ist, die sowohl zu der ersten Richtung (X) als auch zu der zweiten Richtung (Y) orthogonal ist,
eine Expansionskammer (15), in der mindestens jedes Ende (60a, 60b, 60c, 60d) der Produktionsmittel (2a, 2b, 2c, 2d) untergebracht ist;
eine Ablagerungskammer (5), Folgendes umfassend:

• besagtes Substrat (4)
• ein Mittel (7) zum Greifen des Substrats (4), das in der Lage ist, besagtes Substrat (4) in die zweite Richtung (Y) zu bewegen
• eine Vielzahl von Masken (11, 11a, 11b, 11c, 11d), jede umfassend eine Öffnung (12, 12a, 12b, 12c, 12d), wobei jede Maske entlang der ersten Richtung (X), die die Ausbreitungsrichtung des Strahls definiert, zwischen einem Produktionsmittel (2a, 2b, 2c, 2d) und dem Substrat (4) angeordnet ist, sodass besagte Masken ebenfalls die Form mindestens einer ersten Säule (13) und einer zweiten Säule (14), die in Bezug aufeinander in der zweiten Richtung (Y) versetzt sind, aufweisen, wobei die erste Säule (13) und die zweite Säule (14) jeweils mindestens eine Maske umfassen, wobei besagte mindestens eine Maske (11a, 1b) der ersten Säule (13) des Weiteren in Bezug auf besagte mindestens eine Maske (11c, 11d) der zweiten Säule (14) entlang der dritten Richtung (Z) versetzt ist, und sodass die Masken (11, 11a, 11b, 11c, 11d), weiterhin in der ersten Richtung (X), die die Ausbreitung des Strahls definiert, durch einen ersten Abstand d1 vom Divergenzpunkt P des Strahls (3) und durch einen zweiten Abstand d2 vom Substrat (4) getrennt sind und jede Öffnung (12a, 12b, 12c, 12d) mit einem Zentrum (Ca, Cb, Cc, Cd) ausgestattet ist, durch das die Längsachse des verbundenen Produktionsmittels verläuft, wobei die Zentren (Ca, Cb ; Cc, Cd) zweier nächstgelegener und zu verschiedenen Säulen (13, 14) gehörender Öffnungen durch einen Abstand a in der dritten Richtung (Z) und einen Abstand b in der zweiten Richtung (Y) getrennt sind, wobei jede Öffnung (12a, 12b, 12C, 12d) einer Maske in einen Kreis mit dem Durchmesser $2d_1 sin\alpha$ einschreibbar ist,

wobei die Öffnung (12a, 12c) besagter mindestens einen Maske der ersten Säule (13) Folgendes definiert:

- einen ersten, zentralen, Abschnitt (23), dessen Länge L1, die entlang der zweiten Richtung (Y) definiert ist, konstant ist, und dessen Höhe H1, die in der dritten Richtung (Z) definiert ist, ebenfalls konstant ist,
- einen zweiten Abschnitt (21), dessen Breite L3, die in der zweiten Richtung (Y) definiert ist, in der dritten Richtung (Z) variabel ist,

wobei die Öffnung (12b, 12d) besagter mindestens einen Maske der zweiten Säule (14) Folgendes definiert

- einen dritten, zentralen, Abschnitt (24), dessen Länge L2, die in der zweiten Richtung (Y) definiert ist, konstant und gleich der Breite L1 ist und deren Höhe H3, die in der dritten Richtung (Z) definiert ist, ebenfalls konstant ist, und
- einen vierten Abschnitt (22), dessen Breite L4, die in der zweiten Richtung (Y) definiert ist, in der dritten Richtung (Z) variabel ist,

wobei besagter erster Abschnitt (21) und besagter vierter Abschnitt (22) zum einen zwischen besagtem ersten Abschnitt (23) und besagtem dritten Abschnitt (24) angeordnet sind und zum andern eine identische maximale Höhe H2, die in der dritten Richtung (Z) definiert ist, aufweisen wobei die Summe S = L3 + L4 der variablen Breiten entlang der dritten Richtung des zweiten Abschnitts (21) und des vierten Abschnitts (22) besagter Masken, wenn diese gegenüber voneinander entlang der dritten Richtung (Z) angeordnet sind, konstant und gleich L1 sind, wobei ferner die folgenden Beziehungen eingehalten werden:

$$a = \frac{1}{f}\left(\frac{H_1}{2} + H_2 + \frac{H_3}{2}\right) \quad \text{et} \quad b \geq \frac{1}{f}\frac{L_1}{2}$$

wobei:

$$f = \frac{d_1}{d_1 + d_2}$$

2. Vorrichtung nach Anspruch 1, wobei die Öffnung (12a, 12c) besagter mindestens einen Maske der ersten Säule (13) und die Öffnung (12b, 12d) besagter mindestens einen Maske der zweiten Säule (14) verschiedene Formen aufweisen.

3. Vorrichtung nach Anspruch 1, wobei die Öffnung (12a, 12c) besagter mindestens einen Maske der ersten Säule (13) und die Öffnung (12b, 12d) besagter mindestens einen Maske der zweiten Säule (14) identische Formen aufweisen.

4. Vorrichtung nach einem der vorstehenden Ansprüche, wobei die Öffnung (12a, 12c) besagter mindestens einen Maske der ersten Säule (13) und die Öffnung (12b, 12d) besagter mindestens einen Maske der zweiten Säule (14) eine hexagonale Form aufweisen.

5. Vorrichtung (1) nach dem vorstehenden Anspruch, wobei die Maske ein Band (26) umfasst, dass sich entlang der dritten Richtung (Z) erstreckt und jede Öffnung in zwei trennt.

6. Vorrichtung (1) nach einem der vorstehenden Ansprüche, umfassend mindestens ein System zur Ablagerung (6a, 6b) einer Matrix auf dem Substrat.

7. Vorrichtung (1) nach einem der vorstehenden Ansprüche, umfassend eine Vielzahl von Systemen (6a, 6b) zur Ablagerung einer Matrix auf dem Substrat, wobei besagte Systeme (6a, 6b) zur Ablagerung in Bezug auf die erste Richtung (X) symmetrisch angeordnet sind.

8. Vorrichtung (1) nach einem der vorstehenden Ansprüche, wobei die Position des oder jedes Systems (6a, 6b) zur Ablagerung der Matrix auf dem Substrat einstellbar ist, um beispielsweise den Abstand zwischen dem besagten System und dem Substrat und/oder den Ablagerungswinkel der Matrix in Bezug auf das Substrat zu verändern.

9. Montage, umfassend eine Vorrichtung (1) nach einem der vorstehenden Ansprüche und ein System (40) der Zuführung von Partikeln, die für die Speisung der Produktionsmittel (2a, 2b, 2c, 2d) der besagten Vorrichtung (1) bestimmt sind, wobei das System (40) Mittel (28, 29, 30, 31, 32, 33), die dazu geeignet sind, ein Aerosol zu erzeugen, eine kritische Öffnung (34), einen Strömungsabscheider (35), einen Verteilerflansch (37) zu den Produktionsmitteln (2a, 2b, 2c, 2d) und ein Puffervolumen (36) zwischen der kritischen Öffnung (36) und dem Strömungsabscheider (35) umfasst, wobei in dem System (40) die kritische Öffnung (36) vor dem Strömungsabscheider (35) angeordnet ist.

10. Montage nach dem vorstehenden Anspruch, wobei das Volumen der Leitung oder Leitungen (41) zwischen der kritischen Öffnung (34) und dem Strömungsabscheider (35) kleiner oder gleich 10 cm3 ist.

11. Montage nach einem der Ansprüche 9 oder 10, wobei die Leitungen (42) zwischen dem Strömungsabscheider (35) und dem Verteilerflansch (37) gerade oder leicht gekrümmt sind.

**Claims**

1. Device (1) for depositing nanometric sized particles on a substrate (4) wherein the device (1) comprises:

   - means (2a, 2b, 2c, 2d) called production means, each able to produce, from an end (60a, 60b, 60c, 60d) of the production means (2a, 2b, 2c, 2d), a jet (3) of nanometric sized particles, each of said production means being configured to have a longitudinal axis oriented in a first direction (X) defining an axis of propagation of the jet (3), and configured so that the jet (3) is divergent from a point P of divergence with a half-angle of divergence $\alpha$ with respect to its axis of propagation, the production means being arranged so that the various longitudinal axes are parallel to each other and in the form of at least one first column (9) and one second column (10) offset against each other in a second direction (Y) orthogonal to the first direction (X), where the first column (9) and the second column (10) each comprise at least one production means (2a, 2b, 2c, 2d), said at least one production means (2a, 2b, 2c, 2d) of the first column (9) being moreover offset with respect to said at least one production means (2a, 2b, 2c, 2d) of the second column (10) in a third direction (Z), both orthogonal to the first direction (X) and to the second direction (Y),
   - an expansion chamber (15), wherein at least each end (60a, 60b, 60c, 60d) of the production means (2a, 2b, 2c, 2d) is housed;
   - a deposition chamber (5) comprising:

     • said substrate (4)
     • a means (7) for gripping the substrate (4), able to move said substrate (4) in the second direction (Y)
   • a plurality of masks (11, 11a, 11b, 11c, 11d) each comprising an opening (12, 12a, 12b, 12c, 12d), each mask being situated, in the first direction (X) defining the direction of propagation of the jet, between a production means (2a, 2b, 2c, 2d) and the substrate (4) and therefore said masks are also presented in the form of at least one first column (13) and one second column (14) offset against each other in the second direction (Y), where the first column (13) and the second column (14) each comprise at least one mask, said at least one mask (11a, 11b) of the first column (13) being moreover offset with respect to said at least one mask (11c, 11d) of the second column (14) in the third direction (Z), and therefore, always in the first direction (X) defining the propagation of the jet, the masks (11, 11a, 11b, 11c, 11d) are separated by a first distance $d_1$ from the point P of divergence of the jet (3) and by a second distance $d_2$ of the substrate (4) and each opening (12a, 12b, 12c, 12d) being provided with a centre (Ca, Cb, Cc, Cd) through which passes the longitudinal axis of the associated production means, the centres (Ca, Cb; Cc, Cd) of two openings closest and belonging to different columns (13, 14) being separated by a distance a in the third direction (Z) and a distance b in the second direction (Y),

     each opening (12a, 12b, 12c, 12d) of a mask being inscribable in a circle of diameter $2d_1 sin\alpha$,
     the opening (12a, 12c) of said at least one mask of the first column (13) defining:

   - a first central portion (23), of which the width $L_1$, defined in the second direction (Y), is constant, and of which the height $H_1$, defined in the third direction (Z), is also constant,
   - a second portion (21), of which the width $L_3$, defined in the second direction (Y), is variable in the third direction (Z),

the opening (12b, 12d) of said at least one mask of the second column (14) defining:

   - a third central portion (24), of which the width $L_2$, defined in the second direction (Y), is constant and equal to the width $L_1$, and of which the height $H_3$, defined in the third direction (Z), is also constant, and
   - a fourth portion (22), of which the width $L_4$,

defined in the second direction (Y), is variable in the third direction (Z),

said second portion (21) and fourth portion (22) being, on the one hand, situated between said first portion (23) and third portion (24) and having, on the other hand, a maximum height $H_2$, defined in the third identical direction (Z),
the sum $S = L_3 + L_4$ of the variable widths in the third direction of the second portion (21) and the fourth portion (22) of said masks, when the latter are placed opposite each other, in the third direction (Z), being constant and equal to $L_1$, the following relationships being furthermore respected:

$$a = \frac{1}{f}\left(\frac{H_1}{2} + H_2 + \frac{H_3}{2}\right) \text{ and } b \geq \frac{1}{f}\frac{L_1}{2}$$

where:

$$f = \frac{d_1}{d_1 + d_2}$$

2. Device according to claim 1, wherein the opening (12a, 12c) of said at least one mask of the first column (13) and the opening (12b, 12d) of said at least one mask of the second column (14) have various shapes.

3. Device according to claim 1, wherein the opening (12a, 12c) of said at least one mask of the first column (13) and the opening (12b, 12d) of said at least one mask of the second column (14) have identical shapes.

4. Device (1) according to one of the preceding claims, wherein the opening (12a, 12c) of said at least one mask of the first column (13) and the opening (12b, 12d) of said at least one mask of the second column (14) have a hexagonal shape.

5. Device (1) according to the preceding claim, wherein the mask comprises a strip (26) which extends in the third direction (Z) and separating each opening into two.

6. Device (1) according to one of the preceding claims, comprising at least one system for depositing (6a, 6b) a matrix on the substrate.

7. Device (1) according to one of the preceding claims comprising a plurality of systems (6a, 6b) for depositing a matrix on the substrate, said deposition systems (6a, 6b) being arranged symmetrically with respect to the first direction (X).

8. Device (1) according to one of the preceding claims, wherein the position of the or of each system (6a, 6b) for depositing the matrix on the substrate is adjustable, for example to make the distance vary between said system and the substrate and/or the deposition angle of the matrix with respect to the substrate.

9. Assembly comprising a device (1) according to one of the preceding claims and a system (40) for transporting particles intended to supply the production means (2a, 2b, 2c, 2d) of said device (1), the system (40) comprising means (28, 29, 30, 31, 32, 33) able to generate an aerosol, a critical orifice (34), a flow separator (35), a flange (37) for distributing the production means (2a, 2b, 2c, 2d) and a buffer volume (36) situated between the critical orifice (36) and the flow separator (35), system (40) wherein, the critical orifice (36) is placed before the flow separator (35).

10. Assembly according to the preceding claim, wherein the volume of the pipe(s) (41) between the critical orifice (34) and the flow separator (35) is less than or equal to $10\text{cm}^3$.

11. Assembly according to one of claims 9 or 10, wherein pipes (42) between the flow separator (35) and the distribution flange (37) are straight or slightly curved.

**Fig. 1**

**Fig. 2**

Fig. 3b

Fig. 3a

*Fig. 4b*

*Fig. 4a*

*Fig.5*

*Fig.7*

Fig. 6b

Fig. 6a

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2530562 A
- EP 2553135 B1

- EP 2695967 A1